**Europäisches Patentamt**

**European Patent Office**

**Office européen des brevets**

(19)

(11) Publication number : **0 283 724 B1**

# EUROPEAN PATENT SPECIFICATION

(12)

(45) Date of publication of patent specification :
10.05.95 Bulletin 95/19

(51) Int. Cl.⁶ : **G06F 17/50**

(21) Application number : **88102436.8**

(22) Date of filing : **19.02.88**

(54) Method to efficiently reduce the number of connections in a circuit.

(30) Priority : **20.03.87 US 28277**

(43) Date of publication of application :
**28.09.88 Bulletin 88/39**

(45) Publication of the grant of the patent :
**10.05.95 Bulletin 95/19**

(84) Designated Contracting States :
**DE FR GB IT**

(56) References cited :
**IEEE TRANSACTIONS ON COMPUTERS, vol. C-35, no. 1, January 1986, pages 77-81, IEEE, New York, US; L. TREVILLYAN et al.: "Global flow analysis in automatic logic design"**
**IEEE TRANSACTIONS ON COMPUTERS, vol. C-32, no. 10, October 1983, pages 947-952, IEEE, New York, US; D. BRAND: "Redundancy and don't cares in logic synthesis"**

(56) References cited :
**IEEE TRANSACTIONS ON COMPUTER-AIDED DESIGN, vol. CAD-6, no. 6, November 1987, pages 1062-1081, IEEE, New York, US; R.K. BRAYTON et al.: "MIS: A multiple-level logic optimization system"**

(73) Proprietor : **International Business Machines Corporation**
**Old Orchard Road**
**Armonk, N.Y. 10504 (US)**

(72) Inventor : **Berman, Charles L.**
**156 Chambers Street**
**New York, NY 10007 (US)**
Inventor : **Trevillyan, Louise H.**
**RFD 3, Todd Road**
**Katonah, NY 10536 (US)**

(74) Representative : **Schäfer, Wolfgang, Dipl.-Ing.**
**IBM Deutschland Informationssysteme GmbH**
**Patentwesen und Urheberrecht**
**D-70548 Stuttgart (DE)**

## Description

Background of the Invention

This invention is directed to logic design, and more particularly to a method of taking a provided network configuration which may be the result of an automated logic design, and producing therefrom a final network configuration which is the functional equivalent of, and contains fewer connections than, the provided network configuration. Reference is made to a related application, EP-A-168,650.

As the complexity of processors has increased, the task of processor logic design has become more difficult. The designer may begin by designing a flow chart or other register-transfer level description to describe the intended operation of the processor, and the processor operation is then simulated from this description in order to ensure that a processor operating in accordance with the flow chart will provide the desired results. A logic implementation is then designed to achieve the operation described in the flow chart, and the resulting logic diagram and original flow chart specification are compared to ensure consistency. Finally, a physical layout is designed in accordance with the logic implementation.

The above process has become significantly more difficult and extraordinarily time consuming with the increasing complexity of the processors being designed. For example, each chip in the 3081 processor available from International Business Machines Corporation includes over 700 circuits capable of performing extremely complex functions.

The flow chart specification of such processor will be quite complex, and even a first attempt at logic diagram implementation will require a substantial amount of time. Further, with increasing processor complexity, the competing interests of gate count and timing constraints become increasingly difficult to satisfy. More particularly, a typical timing constraint may be that a signal must be provided from the output of register A to the input of register B within some predetermined period of time, and the designer may first propose a logic arrangement intended to satisfy this timing constraint while using a minimal number of gates in the circuit path between registers A and B. After timing analysis, however, it may be discovered that the timing constraint has not been satisfied, and the designer must then revise the arrangement of logic between the registers A and B, e.g., by using a larger number of gates to improve the processing speed in that area. Several iterations of design may be required before a logic design is obtained which indeed satisfies all timing constraints with the minimum gate count, and it is therefore not uncommon for the logic design to be quite costly in terms of engineering time.

In view of the above, there has been significant recent activity in the field of automatic logic synthesis. Early work centered on developing algorithms for translating a boolean function into a minimum 2-level network of boolean primitives, and extensions were developed for handling limited circuit fan-in and alternative cost functions. However, because these algorithms employ 2-level minimization, the time required to implement these algorithms increases exponentially with the number of circuits. The use of such algorithms therefore becomes impractical in designing large processors.

Other efforts have attempted to raise the level of specification, e.g., by beginning with behavioral specifications and producing technology-independent implementations at the level of boolean equations. However, the results of such techniques were usually more expensive than manual implementations and did not take advantage of the target technology. For example, the system described by T.D. Friedman et al, in "METHODS USED IN AN AUTOMATIC LOGIC DESIGN GENERATOR (ALERT)", IEEE Trans. Computers C-18, 593-614 (1969), produced implementation for an IBM 1800 processor which required 160% more gates than the manual design for that same processor. Several attempts have been made to produce more efficient logic and to give the designer more control over the implementation, e.g., as described by: H. Schorr, "TOWARD THE AUTOMATIC ANALYSIS AND SYNTHESIS OF DIGITAL SYSTEMS", Ph.D. Thesis, Princeton University, NJ, 1962; C.K. Mestenyi, "COMPUTER DESIGN LANGUAGE SIMULATION AND BOOLEAN TRANSLATION", Technical Report 68-72, Computer Science Department, University of Maryland, College Park, MD, 1968; F.J. Hill and G.R. Peterson, "DIGITAL SYSTEMS: HARDWARE ORGANIZATION AND CONTROL", John Wiley & Sons, Inc., New York, 1973. However, this control has resulted in specification language constraints, so that the specification is at a fairly low level and in closer correspondence with the implementation. This necessarily decreases the advantage of an automated approach, bringing it closer to a system for logic entry rather than logic synthesis.

Several tools have been developed to support the early part of the design cycle, e.g., as described in: M. Barbacci, "AUTOMATED EXPLORATION OF THE DESIGN SPACE FOR REGISTER TRANSFER SYSTEMS", Ph.D. Thesis, Carnegie-Mellon University, Pittsburgh, PA, 1973; D.E. Thomas, "THE DESIGN AND ANALYSIS OF AN AUTOMATED DESIGN STYLE SELECTOR", Ph.D. Thesis, Carnegie-Mellon University, Pittsburgh, PA, 1977; E.A. Snow, "AUTOMATION OF MODULE SET INDEPENDENT REGISTER-TRANSFER LEVEL DESIGN", Ph.D. Thesis, Carnegie-Mellon University, Pittsburgh, PA, 1978; L.J. Hafer and A.C. Parker, "REGISTER-TRANSFER LEVEL DIGITAL DESIGN AUTOMATION: THE ALLOCATION PROCESS", Proceedings of the Fifteenth Design Automation Conference, Las Vegas, NV, 1978, pp. 213-219; A. Parker, D. Thomas, D. Siewiorek, M. Barbacci, L. Hafer, G. Leive, and J. Kim, "THE CMU DESIGN AUTOMATION SYSTEM - AN EXAMPLE OF AUTOMATED DATA PATH DESIGN", Proceedings of the Sixteenth Design Automation Conference, Las Vegas, NV, 1978, pp. 73-80. The technique described in the last-cited publication began with a functional description of a machine and produced an implementation in two technologies of the registers, register operators and their inter-connections, but not the control logic to sequence the register transfers. For both TTL and CMOS implementations, however, the automated implementation required substantially more chip area than existing manual designs.

The automatic optimisation of a logic circuit is also described in an article entitled "Global Flow Analysis in Automatic Logic Design" by L. Trevillyan et al. published in the IEEE Transactions on Computers, vol C-35, no 1, January 1986, pp 77-81. In this article, the principles of a so-called compiler-like approach to automatic design optimisation are described. The logic of the circuit is represented in the form of a directed graph in which the nodes, i.e. the logical components of the circuit, are connected together by directed edges, i.e. by connections in the circuit. Improvements to the logic graph can be made by decreasing either the number of nodes or by decreasing the number of sinks, i.e. by eliminating unnecessary logical components in the circuit, whilst maintaining the function of the graph. The article then describes an algorithm by means of which the signals in the graph can be deleted from the nodes without changing the function of the logic of the circuit.

There has also been recent work in logic remapping, i.e., transforming existing implementations from one technology to another. S. Nakamura et al, "LORES-LOGIC REORGANIZATION SYSTEM", Proceedings of the Fifteenth Design Automation Conference, Las Vegas, NV, 1978, pp. 250-260; describe a system which will help a designer translate an existing small or medium-scale integration. However, remapping usually involves one-to-one substitution of new technology primitives for old technology primitives, and this often fails to take advantage of simplification which may be available at a higher technology-independent level.

European Patent application EP-A-168,650, entitled "LOGIC SYNTHESIZER" sets forth a logic synthesis method in which a register-transfer level flowchart specification is translated in a straightforward manner into a simple AND/OR logic implementation. After expanding the logic implementation to elementary representation and then applying textbook simplifications, the simplified AND/OR implementation is translated to a NAND or NOR implementation, depending on the target technology. The NAND or NOR implementation is then simplified by applying a sequence of simplification transformations which achieve satisfactory results, with the transformation sequence being modified to achieve "normal," "fast" or "small" logic designs. After simplification at the NAND/NOR level, the logic implementation is then translated to the target technology and further simplified. The result is an interconnection of the primitives of the target technology in a language from which automated logic diagrams can be produced in a known manner, and which can be submitted to existing programs for automated placement and wiring and chip fabrication.

## Summary of the Invention

The invention is set out in claim 1.

According to the present invention, as claimed, a method is set forth for taking a provided logical design or an original circuit implementation, e.g. as set forth in the cited EP-A-168,650, and producing therefrom a final circuit implementation which is the functional equivalent of, and contains fewer connections than, the original circuit implementation. This is the result of approaching connection minimization globally rather than utilizing local transformation as in the prior art. For example, a semiconductor chip such as a master slice chip which is connected in a given circuit configuration has the number of connections between elements minimized. Stated another way, the idea is to minimize connections between terminals or nodes on the master slice chip. Each of n signals is processed in a circuit configuration sequentially. For each such signal in the given circuit a derived graph is constructed. The minimal cut of the derived graph is found, and this cut is utilized to optimize the circuit. The next signal is processed in the optimized circuit, and this procedure is repeated until all n signals have been processed. The resulting optimized circuit is the functional equivalent of the original circuit, but has fewer connections.

## Brief Description of the Drawings

Fig. 1 is a schematic diagram of a provided logic circuit implementation in a given technology:
Fig. 2 is a derived graph of the logic circuit of Fig. 1;
Fig. 3 is a schematic diagram of an optimized logic circuit implementation, which is the functional equivalent of the logic circuit of Fig. 1, but which has fewer connections;

Fig. 4 is a flow chart which is indicative of the connection reduction overview of the method of the invention;

Figs. 5 through 9 are flow charts which are indicative of the first phase of the method according to the invention, which computes global information relative to the logic circuit of Fig. 1;

Figs. 10 through 12 are flow charts which are indicative of how the derived graph of Fig. 2 is arrived at in the first steps of the second phase of the method according to the invention;

Fig. 13 is a flow chart which is indicative of the max-flow/min-cut processing in the second step of the second phase of the method according to the invention; and

Fig. 14 is a flow chart which is indicative of how the optimized logic circuit of Fig. 3 is arrived at in the third step of the second phase of the method according to the invention.

## Brief Disclosure of the Invention

A provided network configuration includes n signals and m nodes. A final network configuration is produced therefrom which is the functional equivalent of, and contains fewer connections than, the provided network configuration. Global information is computed relative to a chosen one of the n signals, and a derived graphical representation of connections between the m nodes is generated from the global information. A list of nodes that form a cut-set of the derived graph is produced from the graphical representation, and a new network is provided as a function thereof. Each of the remaining ones of the n signals are processed sequentially, as above, to form successive new networks with the processing of the final signal resulting in the final network configuration.

## Best Mode for Carrying Out the Invention

A system is set forth for minimizing the connections in an original or a provided logical design. The design may come from any source, for example, a logic design system, with the idea being to produce an optimized logical design which is the functional equivalent of the original or provided logical design, but which has fewer connections. This is accomplished in the practice of the invention, by a method which may be practiced on a properly programmed computer such as the IBM System/370 data processing system, as defined by the "System/370 Principles of Operation" manual, Form No. GA22-7000. It is to be appreciated, however, that the invention may be practiced on any general purpose computer or machine.

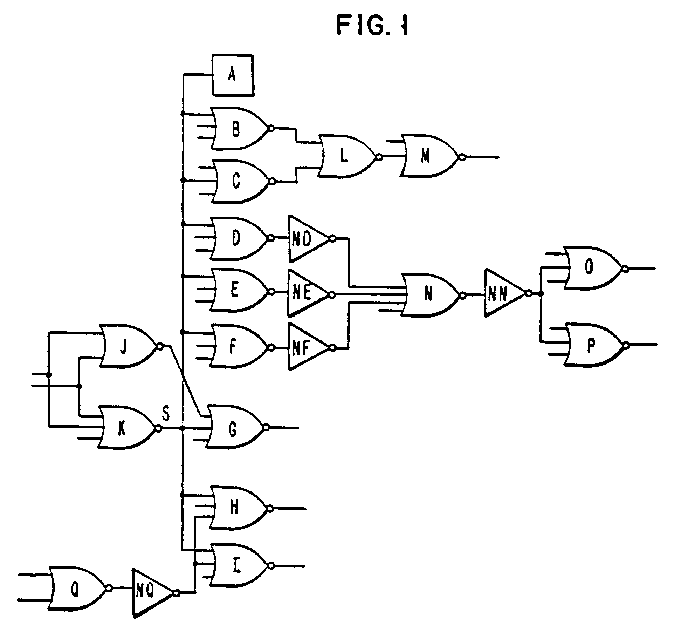

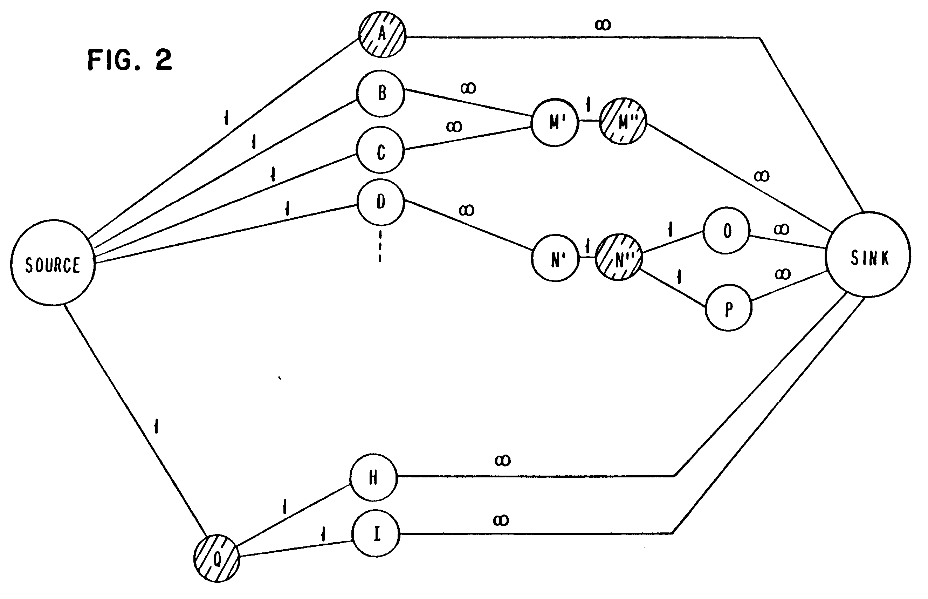

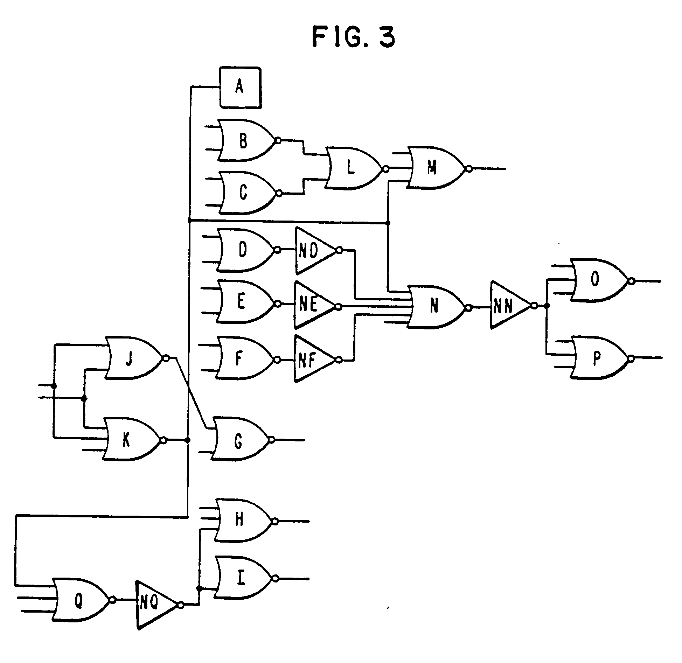

A provided or original logical design or circuit, as shown in Fig. 1 which includes n signals and m nodes has global information computed relative to a chosen one of the n signals. A derived graph of connections between nodes, as shown in Fig. 2, is constructed from the global information. A list of nodes in the derived graph that form a cut-set are found and a new logical design is produced therefrom. Each of the remaining ones of the n signals are processed sequentially, as above, to form successive new logical designs, with the processing of the nth signal resulting in an optimized logical design as shown in Fig. 3.

Stated another way, it is determined which of the m nodes comprise FRONTIER nodes for a given one of the n signals in the original logic circuit. Then, a different set of connections is determined which generate the same set of FRONTIER nodes for the given one of the n signals. Next, the original set of connections in the original circuit are replaced with the different set of connections for producing a different logic circuit. Finally, the above is repeated for each of the remaining ones of the n signals, with the original logic circuit being replaced by the different logic circuit, with the completion of the repetition of steps resulting in a new or optimized logic circuit. The detailed description that follows describes how the design of Fig. 1 results in the derived graph of Fig. 2 and finally the optimized design of Fig. 3.

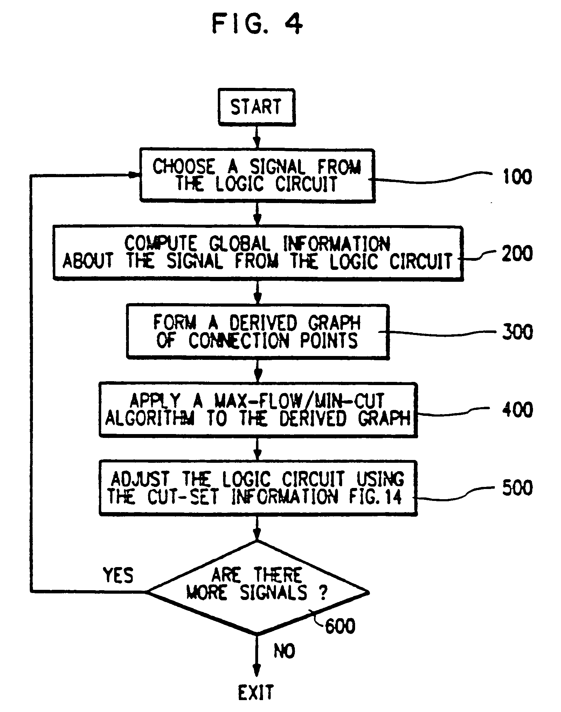

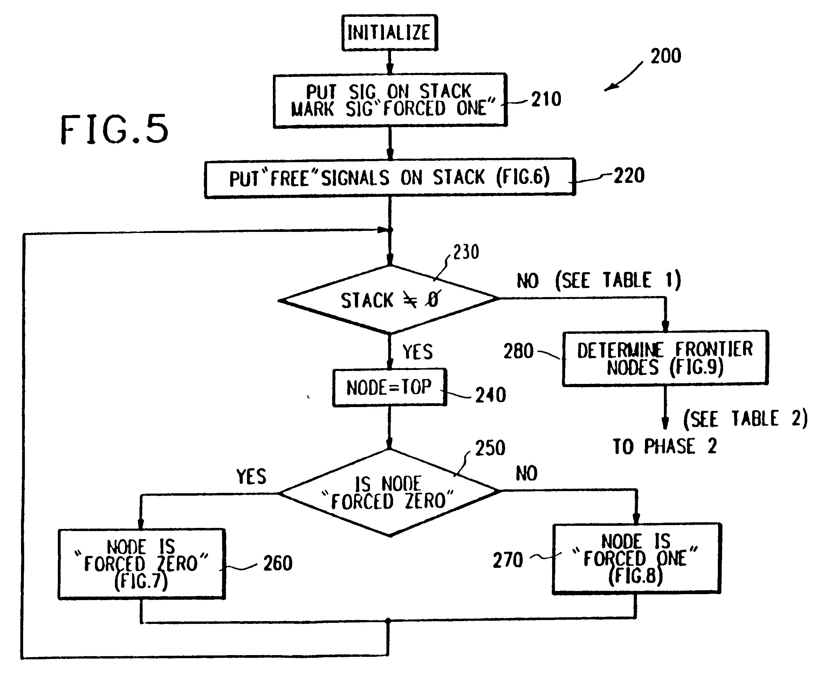

Refer now to Fig. 4 which is a flow chart of the connection reduction overview of the invention. The method starts, and at 100 one of the n signals is chosen for processing, for example the signal s of Fig. 1. At 200 global information is computed relative to the chosen signal. Next, at 300 a derived graph of connection points, as in Fig. 2, is formed from the computed information. A max-flow/min-cut algorithm is applied to the derived graph at 400. The provided logic circuit is adjusted according to the cut-set information. At 600 it is determined if there are any more of the n signals remaining. If so, the method returns to 100 and the process is repeated for each of the remaining ones of the n signals. The nth iteration results in an adjusted logic circuit at 500 which is the optimized logic design as in Fig. 3.

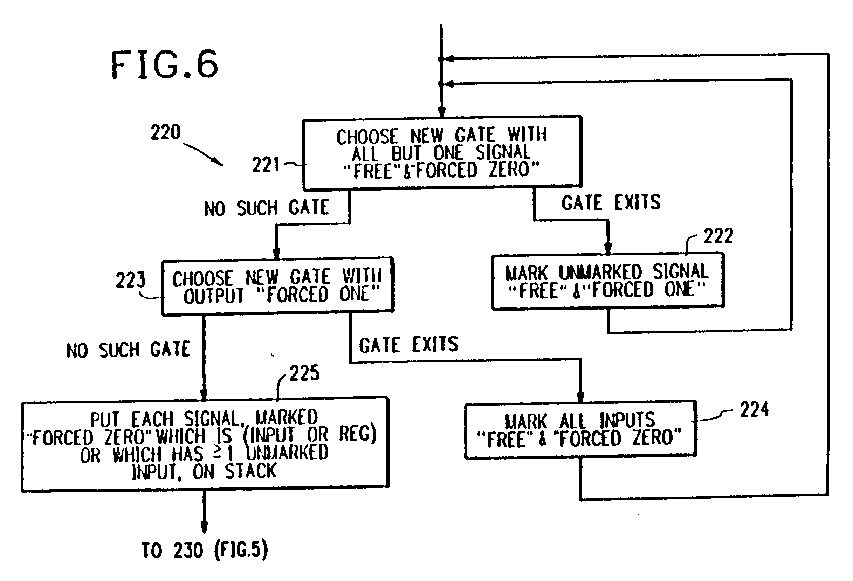

The details of the method of Fig. 4 are set forth below relative to Figs. 5-14.

At the highest level, the method is organized into two phases. The first phase computes information concerning the signals in the circuit under consideration. The information which is computed is described below. In the second phase of the method, a minimal set of connections is determined which results in the same global forcing information at certain key nodes, for example FRONTIER nodes. The main theoretical result, guarantees that if the circuit is changed in such a way that this global information is unchanged at these key nodes, then the circuit computes the same function and this permits the connections of the circuit to be altered safely. The method is designed for a circuit described in terms of NORs; however, this is only for clarity of presentation and is not a limitation of the method itself.

The second phase itself is divided into three parts. First, a graph is built which contains the forcing information (the construction of a "derived graph" as described below), second, a standard MINCUT algorithm is used to find a minimum cut-set of the derived graph, and third the cut-set is used to optimize the circuit.

Data Structures

The method proceeds through the signals of the circuit one by one. The signal currently being processed is referred to as the current signal. In the flow charts the current signal may be referred to as SIG or "SIG". During the processing of each signal, the following data structures are needed. A stack is utilized to hold names of other signals which are encountered during the processing of the current signal. In addition, for each signal in the circuit, a data structure is utilized which holds the following information. This data structure is reinitialized during each pass through the method.

Data Structure For Each Signal

1. fan-in of the gate which produces the signal.
2. fan-out of the signal.
3. whether the signal is FORCED ONE. (This means that if current signal is "1", the signal will be forced to "1".)
4. whether the signal is FORCED ZERO. (This means that if current signal is "1", the signal will be forced to "0".)
5. whether the signal is FREE. (This describes whether all connections of the current signal in the tree driving the signal can be removed without changing the value of the signal. If the signal is FREE all connections can safely be removed.)
6. whether the signal is FRONTIER. (This tells whether the effect of the current signal must be observable at this signal or whether it can be masked by connections of the current signal later in the cone of influence. If a signal (node) is FRONTIER the effect of the current signal must be observable at the signal.)
7. whether the signal is BLOCKED. (This refers to whether a connection of the current signal at the source of this signal would change the output of the circuit. If it is BLOCKED a connection would not change the output.)
8. whether the signal is CHOSEN. (This refers to those nodes for which a node called DG(node) is placed into the derived graph and which have an edge from the source to DG (node). These are among the signals which may end up with the current signal as input.)
9. estimate of the value of a direct connection to the gate producing the signal, w.e
10. estimate of the value of a direct connection to a gate producing an input to the gate producing the signal, w.o
11. number assigned to the signal in some topological ordering of signals in the circuit.

w.e and w.o are used since there are many places where a signal may be connected in a circuit all of which yield equivalent logic. The goal of optimization is to find a set of connections which minimize some objective function. These values are related to the objective function which has been chosen.

I. Information Collection

The respective signals of the circuit are processed sequentially, with information for each signal being collected, and then the connections of that signal are optimized. In speaking of the method a signal is identified with the node which produces that signal. This allows reference to the inputs of a signal. Note that the FORCED ZERO and FORCED ONE assignments are reused with slightly different meanings during the second phase (construction of the derived graph) of the method.

Refer now to Fig. 5 for the process of computing global information for each signal in the original circuit of Fig. 1, and as indicated generally at 200 of Fig. 4. First, the current signal is put on the stack, and marked "FORCED ONE", as indicated at 210. Next at 220, "FREE" signals are put on the stack. Refer now to Fig. 6 for the detailed flow chart of 220. As indicated at 221, an unprocessed gate is found, if one exists, such that all but one of the signals connected to this gate, both inputs and outputs, are marked FORCED ZERO. If such a gate exists, then as indicated at 222 the unmarked signal is marked FORCED ONE and 221 is repeated. If

EP 0 283 724 B1

no such gate exists, then as indicated at 223 find an unprocessed gate with output marked FORCED ONE, and if such a gate exists then as indicated at 224 mark all inputs FORCED ZERO and FREE and repeat 221. If no such gate exists, then as indicated at 225 put those signals, which are the output of a non-combinational gate on the stack. In addition, put those signals on the stack which are marked FORCED ZERO and whose generating boxes have at least one input which is not marked. Also mark each signal on the stack, other than the current signal as FREE. Note that if during the procedure of 220 a signal is ever marked FORCED ONE and FORCED ZERO this indicates that a contradiction is discovered and SIG is set to ZERO in the circuit, and the process moves to the next signal.

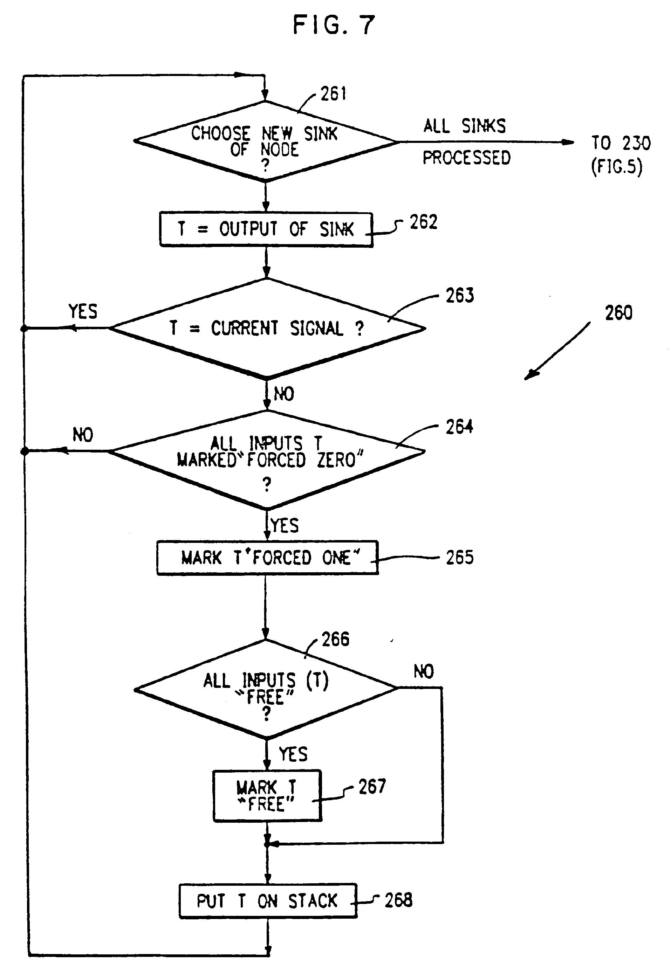

Return now to Fig. 5. The next stage is the main part of the information collection portion of the method. It is a loop which discovers the forcing information which is used to rearrange connections. The loop can be implemented in many ways, and for purposes of description a stack is chosen as indicated at 230. If the stack is not empty, the top element is removed from the stack at 240 (this element will be named by the variable NODE) and the operation proceeds as follows: As indicated at 250 a test is made to determine if the NODE is FORCED ZERO, if it is then go to 260 otherwise go to 270. Refer now to Fig. 7 for the condition when the node is FORCED ZERO. As indicated at 261, an unprocessed sink of NODE is chosen and T is its output as indicated at 262. If no such unprocessed sink exists, all sinks are processed and a return is made to 230 of Fig. 5. If T is the current signal a return is made to 261. If not, proceed from 263 to 264. If some input of T is not marked FORCED ZERO then return to 261. Otherwise mark T FORCED ONE at 265 and proceed to 266. If every input of T is FREE then mark T FREE at 267, if not proceed to 268. Finally, put T on the stack at 268 and return to 261. When all sinks are processed return to 230 of Fig. 5.

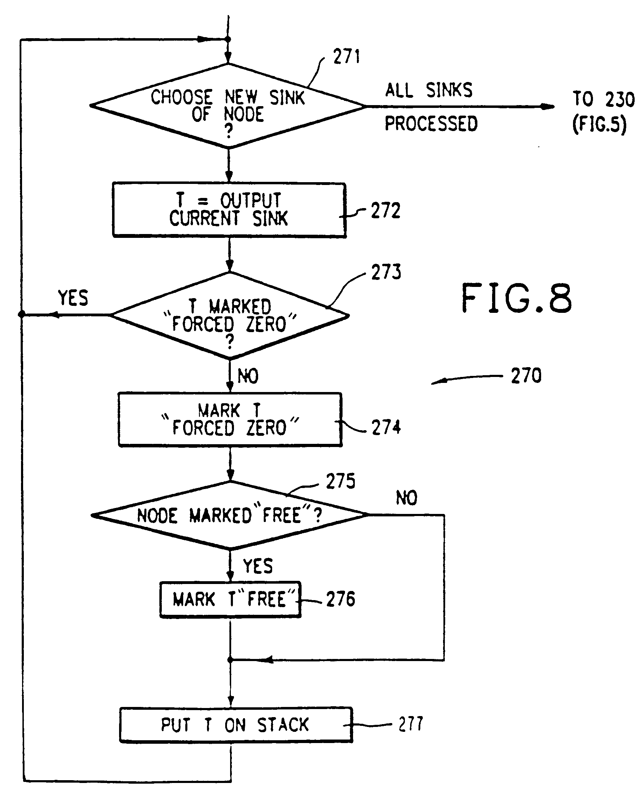

Refer now to Fig. 8 for the condition when the node is FORCED ONE as indicated at 270 of Fig. 5. As indicated at 271, choose an unprocessed sink of NODE and let T be its output as indicated at 272. If no such unprocessed sink exists, return to 230 of Fig. 5. At 273, if T is marked FORCED ZERO, then return to 271, otherwise mark T FORCED ZERO as indicated at 274 and go to 275. If NODE is FREE then mark T FREE as indicated at 276. Finally, put T on the stack as indicated at 277 and return to 271.

Return now to Fig. 5. If the stack is empty at 230, this indicates the computation of all the forcing information is complete. Table 1 below indicates the node markings at the entry to 280 of Fig. 5.

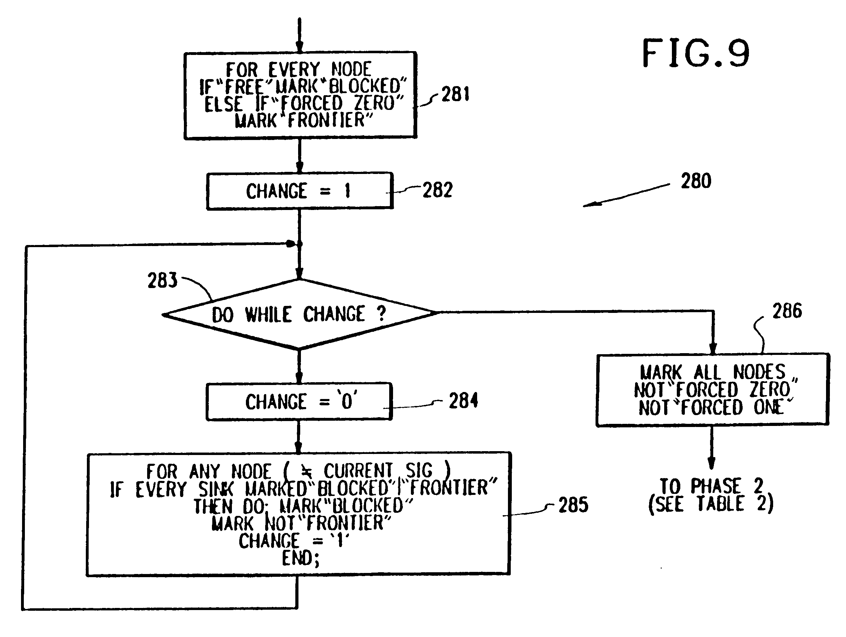

Refer now to Fig. 9 for a detailed determination of FRONTIER nodes, as indicated generally at 280 of Fig. 5. A FRONTIER node is a node which is forced to ZERO by a given signal and from which there is a path to a register, or output to other nodes which are not forced to ZERO. Initially, as indicated at 281 mark each FREE node as BLOCKED and otherwise each FORCED ZERO node as FRONTIER. A loop 283 is entered until there is no further change in the data structures. In this loop for each node, as indicated at 285, if every sink of the node is marked BLOCKED or FRONTIER, mark the node BLOCKED and not FRONTIER. When the loop is complete, proceed to 286 and mark all nodes NOT FORCED ZERO, NOT FORCED ONE. This completes phase one. Table 2 below indicates the node markings at the exit of 280 of Fig. 5, in the example to be described.

At this point the forcing information has been used, and the FRONTIER information has been computed which permits the construction of the derived graph of Fig. 2. The optimization of the logical circuit may now proceed. The FORCED ZERO and FORCED ONE arrays are reinitialized and the construction of the derived graph proceeds as set forth below.

II. Construction of Derived Graph

In what follows it is important to maintain the distinction between nodes in the original circuit of Fig. 1 and nodes in the derived graph of Fig. 2. This is done by always using the terms node, sink of node, predecessor of node, etc. to refer to elements of the original circuit and using the expressions DG (node), DG (sink), etc. to refer to nodes in the derived graph of Fig. 2 which correspond to node or sink in the original circuit of Fig. 1.

In addition, the FORCED ZERO and FORCED ONE fields are reused in a slightly different context. The goal is to produce a derived graph which incorporates enough information to make each FRONTIER Node FORCED ZERO. In this phase at each point the FORCED ZERO and FORCED ONE fields reflect only the forcing which is entailed by the derived graph as it exists up to that point.

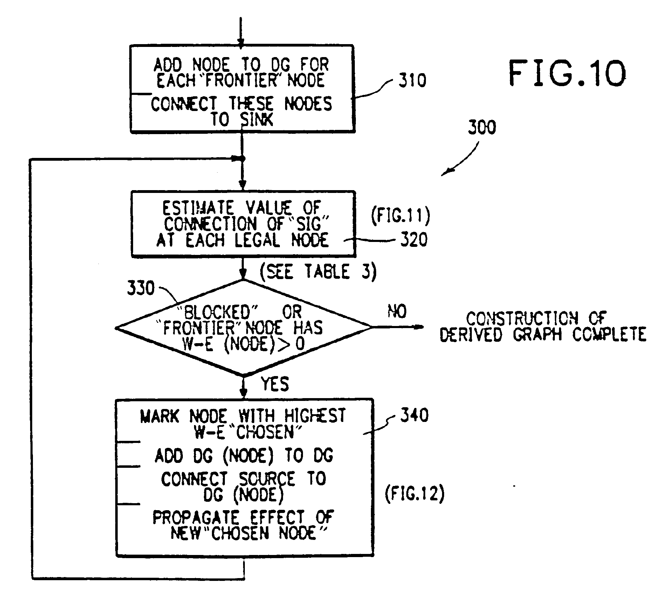

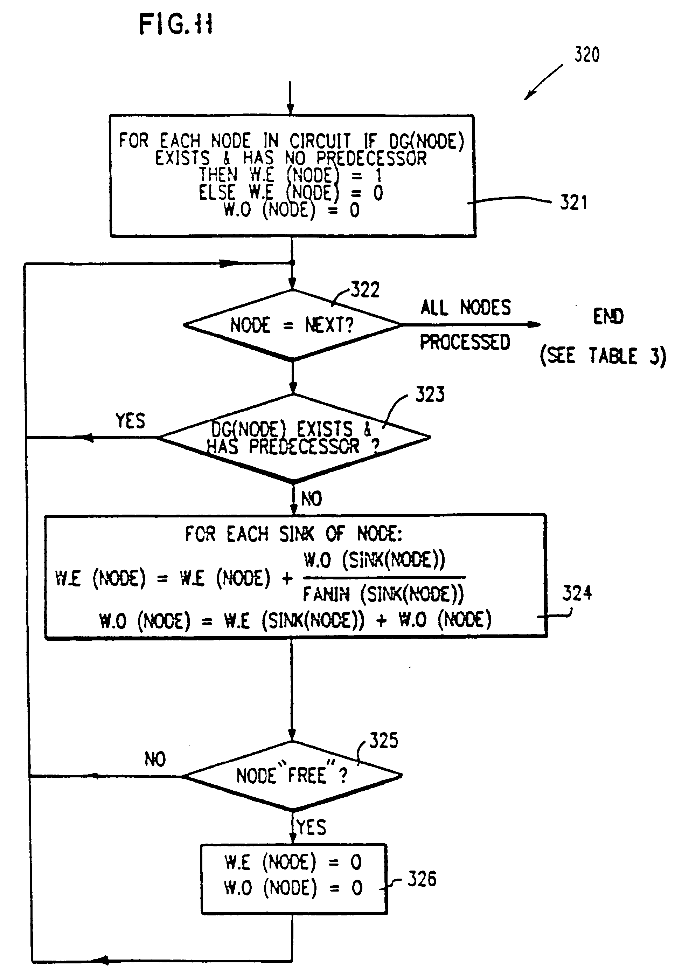

Construction of the derived graph comprises three steps as shown in Fig. 10. First, as indicated at 310, nodes corresponding to the FRONTIER Nodes of the circuit are inserted into the derived graph. After this is done, an iterative procedure is used. Second, as indicated at 320, the value of a connection of the current signal at each legal node in the circuit is estimated. Third, as indicated at 340 the node with the highest value is chosen, a corresponding node is inserted into the derived graph, and the derived graph is updated to reflect all forcing due to nodes currently represented in the derived graph. When this is complete, a return is made to 320. The procedure ends when, at all legal nodes, the value of the connection is zero.

6

Initially, two nodes are placed in the derived graph. One is labelled SOURCE and one is labelled SINK. Then as indicated at 310, for each node labelled FRONTIER in the original circuit, DG (node) is added in the derived graph. Edges are added from each of these nodes to the node labelled SINK.

In order to estimate the value of a connection at a node in the original circuit, as indicated at 320, the data fields w.e and w.o, mentioned earlier, are made use of. Refer now to Fig. 11 for a detailed description of 320. First, w.e and w.o are set to zero for each node. Then, as indicated at 321, for each node in the circuit, with a corresponding node DG (node) in the derived graph, if DG (node) has no in-edges, set w.e (node) = 1. The nodes of the circuit are then processed in reverse topological order as indicated at 322, beginning at the nodes which had w.e (node) set to 1 in the previous step and working backward towards the inputs and registers. Note, that if a node is FREE then w.e remains 0. If DG (node) has a predecessor in the derived graph, as indicated at 323, make no changes to w.e or w.o and choose the next node in the topological sweep. If the node has no corresponding node, DG (node), in the derived graph or if it has a corresponding node but DG (node) has no predecessor, update w.e and w.o with the formula shown in 324. If the node is FREE as tested at 325, proceed to 326 and set w.e and w.o to zero. Return to 322, and when all nodes are processed, w.e will hold an estimate for the value of a connection at any node of the circuit, as shown for example in Table 3 below.

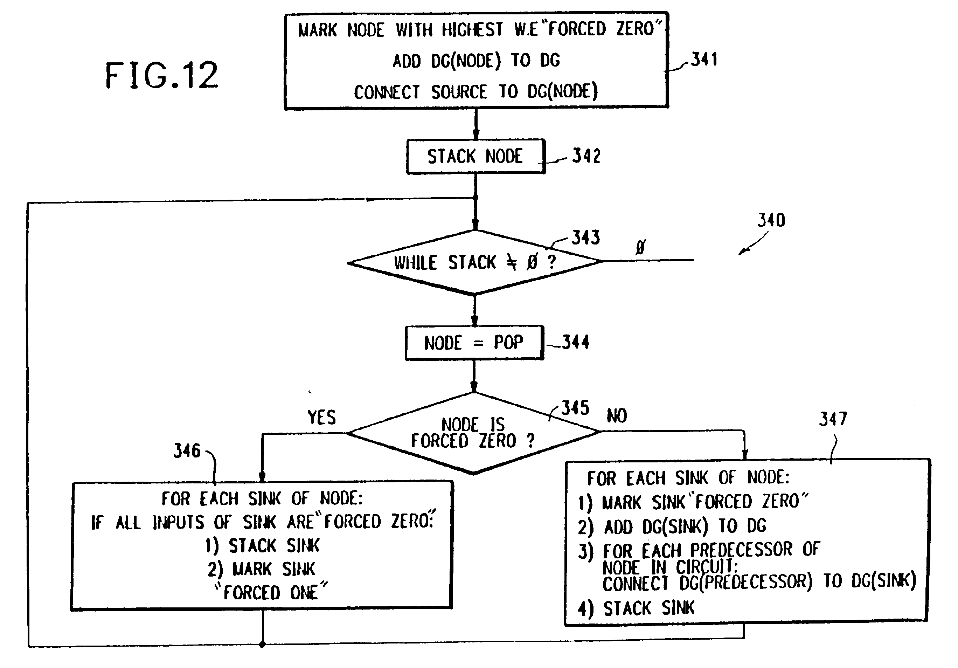

Return now to Fig. 10, where at 330 a determination is made if a "BLOCKED" or "FRONTIER" node has w.e (node) > 0. If not the derived graph is complete, if so proceed to 340. The loop is now entered which completes the construction of the derived graph. During each iteration of the loop, one or more edges are added to the derived graph, at 340. Refer now to Fig. 12 which shows 340 in detail. At 341, the node with largest w.e (node) is chosen. This node is marked CHOSEN and FORCED ZERO and a corresponding node, DG (node), is added to the derived graph. In the derived graph, an edge is put from the SOURCE to DG (node). The node is pushed on the stack at 342. The effect of adding this node is propagated in the loop headed at 343. While the stack is not empty, the top element from the stack is chosen at 344. Then at 345 it is determined if the node is FORCED ZERO. If it is FORCED ZERO then proceed to 346, and for each sink of the node in the circuit, if every input of the sink is marked FORCED ZERO, then mark the sink FORCED ONE and push the sink on the stack. If the node is FORCED ONE then proceed to 347 and for each sink of the node in the original circuit do the following: 1) add a corresponding node, DG (sink), to the derived graph if one is not present, 2) mark the sink FORCED ZERO, 3) for every predecessor of the node in the circuit connect DG (predecessor) to DG (sink), 4) push sink onto stack. Now return to 343. When the stack is empty, one iteration of the loop headed at 320 is complete, and a return is made to 320 of Fig. 10. When no node has w.e > 0, the construction of the derived graph is completed as indicated by the N line of 330.

III. Max-Flow / Min-Cut Algorithm

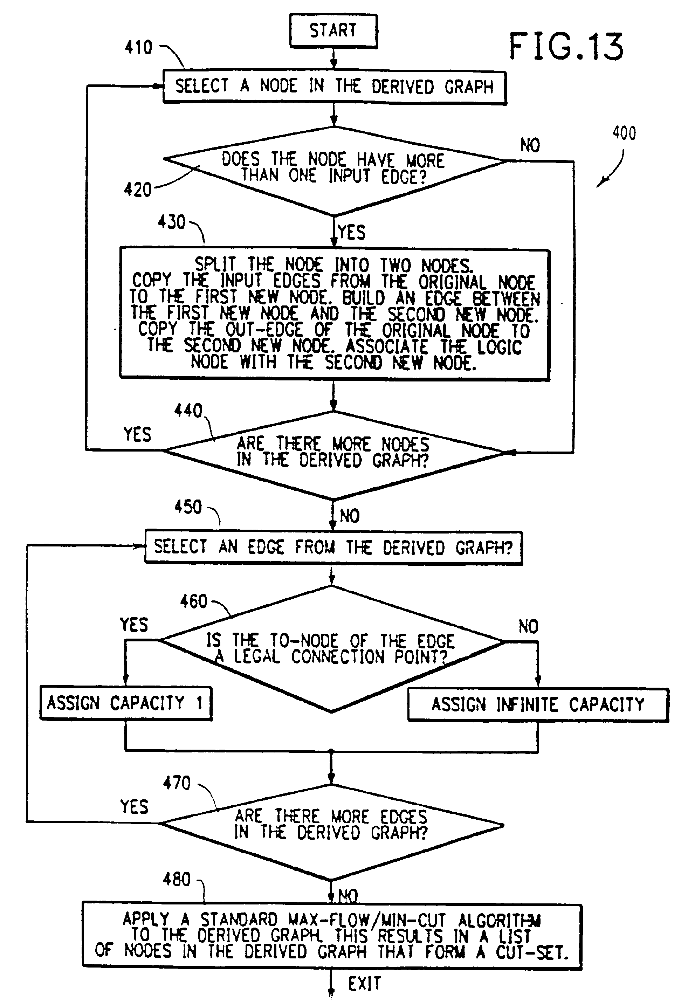

When the derived graph has been completed, it is prepared for the application of a standard max-flow/min-cut algorithm. One such algorithm is described in an article entitled "FLOWS IN NETWORKS", Princeton University Press, Princeton, New Jersey, 1962 by S.R. Ford and D.R. Fulkerson. Refer now to Fig. 13 for the process utilized in the invention. In the usual formulation of max-flow/min-cut problems, the flow capacities are on edges of the graph, but in the derived graph, the capacities are on the nodes. In 410-440, the derived graph is converted to one with edge capacities by splitting each node N that has more than one in-edge into two nodes, N' and N", with an edge between them. N' has the same in-edges as N, but has only one out-edge. N" has only the in-edge which corresponds to the out-edge of N', but it has the original out-edges of N. The edge between N' and N" will carry the capacity associated with derived graph node N.

Next, edge capacities are assigned, as set forth in 450-470, to each edge as follows:

1. If the to-node of the edge corresponds to a legal connection point in the derived graph, at 460, give it capacity 1.

2. Otherwise, the edge has infinite capacity. This includes all of the edges into the N' nodes that were described above, because they do not correspond to any point in the logic graph. It also includes edges to the sink node of the derived graph, and edges which correspond to connections of a signal to a non-NOR node in the logic graph.

Edges are assigned capacity 1 because the algorithm is only minimizing connections. Other weighting functions could also be used to take area and timing into consideration.

Finally, the max-flow/min-cut algorithm is applied to the modified derived graph at 480. The result of this is a list of nodes in the derived graph, called a cut-set, which corresponds to the places that the signal should be connected to in the original logic graph.

IV. Optimize Circuit

The "Optimize Circuit" phase is responsible for posting the information from the max-flow/min-cut algorithm back into the original circuit. It takes the cut-set as input, and must assure that the signal is connected to only the nodes in the original circuit that correspond to nodes in the cut-set of the derived graph. This results in the optimized circuit.

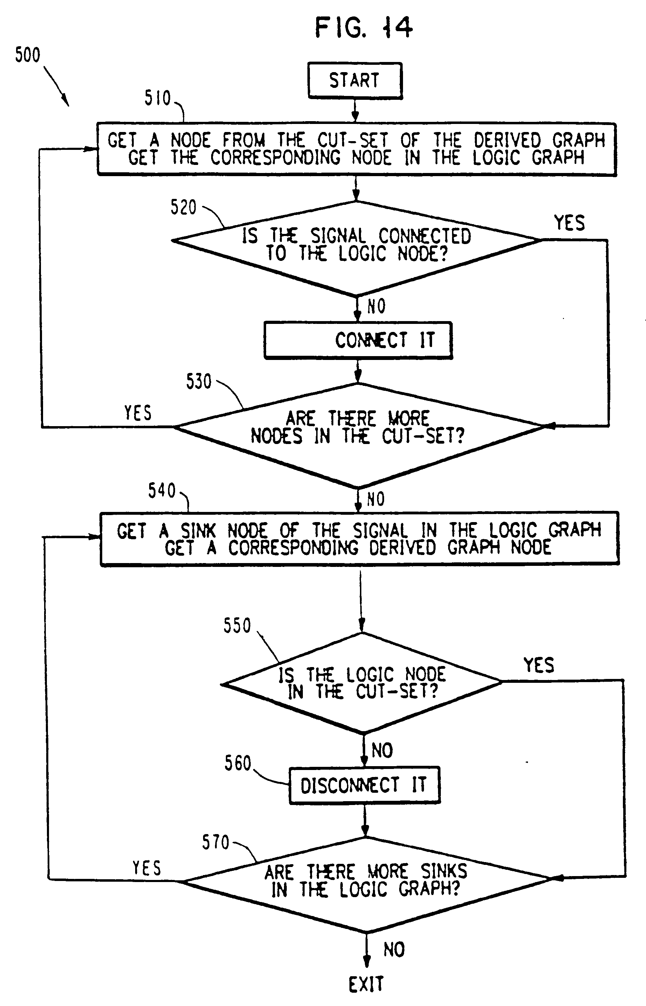

Refer now to Fig. 14 for the optimization procedure. First, it sequences through the cut-set, 510-530. For each derived-graph node in the cut-set, it obtains the corresponding node in the original circuit. If the signal is not connected to the circuit node, it connects it there.

Finally, it sequences through the connections of the signal in the original circuit as shown at 540-570. For each connection to a circuit node, it obtains the corresponding derived graph node. If the derived graph node is not in the cut-set, it disconnects the signal from the circuit node. This results in an optimized circuit where there are only connections found in the cut-set.

A specific example will now be set forth to show how a provided logic network is optimized. As previously stated Fig. 1 shows an example of a provided logic network. All of the devices except the box labelled A represent NORs. Box A represents some non-NOR construct such as a latch or an off-chip driver. In the example, the method or algorithm of the invention is applied to show how the connections of a signal S are optimized. Initially, S is an output from NOR box K, and is connected to nine boxes: A,B,C,D,E,F,G,H and I.

The behavior of the method of the invention is described below relative to the iteration in which the signal "s" shown in Fig. 1 is processed. In what follows, signals are named according to their source boxes or position which they have as input to a box. For example, signal "s" can also be called K.OUT, G.IN.2, or E.IN.1. These names will be used interchangeably.

The iteration is started with SIG = "s". Refer now to Fig. 5, where "s" is put on the stack and marked FORCED ONE at 210. Proceed next to 220 where FREE signals are added to the stack.

For detailed operation of 220 now refer to Fig. 6. The test at 221 is made, and the NO.SUCH.GATE exit to 223 is taken. Node K satisfies the test at 223, so proceed to 224 and mark K.IN.1, K.IN.2, and K.IN.3 FORCED ZERO and FREE. Then return to 221 where gate J now satisfies the test. Now since the gate exists, take the exit to 222 and mark signal J.OUT as FORCED ONE and FREE. Return again to 221 and take the NO.SUCH.GATE exit to 223. Then from 223 take the NO.SUCH.GATE exit. (Both of these exits were taken because of the requirement that a gate be "new", i.e., not previously "processed" to satisfy the test.) Next, go to 225 where K.IN.1, K.IN.2, and K.IN.3 are put on the stack and return to 230 in Fig.5.

The stack is not empty as tested at 230 so assign K.IN.3 to NODE at 240. At the test at 250 it is seen that the NODE is FORCED ZERO so go to 260. Refer now to Fig. 7 for the details of 260. At 261 K is the sink of K.IN.3. Set T = K.OUT at 262 and in 263 it is seen that T is the current signal so return to 261 where it is determined that all sinks of K.IN.3 have been processed, so return to 230 of Fig. 5.

At 230 the stack is again not empty and K.IN.2 is assigned to NODE at 240. At 250 NODE is again FORCED ZERO so go to 260 as before.

Returning to 261 of Fig. 7, eventually T = J.OUT. Then proceed through 263 to 264 where it is found that every input of T is marked FORCED ZERO so go to 265 and mark T (= J.OUT) as FORCED ONE. At 266 it is found that all inputs of T are marked FREE and so mark T FREE at 267. Finally, put T on the stack at 268 and return to 261 and then to 230 of Fig. 5 as before.

Proceed through 230, assign NODE = J.OUT, at 240 and proceed through 250 to 270. Refer now to Fig. 8 for the detail of 270. At 271 choose G, the only sink of the NODE, and then set T = G.OUT at 272. In 273 it is found that T is not marked FORCED ZERO. In 274 mark T FORCED ZERO. In 275 since NODE is FREE, mark T FREE. Then put T on the stack at 277 and return to 271 and then to 230 of Fig. 5.

G.OUT is next removed from the stack and the program proceeds as described above. In the logic circuit shown in Figure 1, the effects of G.OUT do not propagate forward. Therefore, from 261 in Fig. 7 return to 230 and remove first K.IN.1, and thereafter "s" from the stack. The processing of K.IN.1 and "s" proceeds in the same way as the processing of the signals which have just been described. The result is to put all sinks of "s" on the stack, except for G.OUT (this is not put on because of the test at 273 of Fig. 8), and marking all of them FORCED ZERO. Note that none of these signals will be marked FREE, since node "s" is not so marked, again excepting G.OUT which is already marked in this way.

The markings which result from continuing this process until the stack is empty at 230 of Fig. 5 are given in TABLE 1 below.

## TABLE 1

### NODE MARKINGS AT ENTRY TO (280)

| | FREE | FORCED 1 | FORCED 0 |
|---|---|---|---|
| A.OUT | | | X |
| B.OUT | | | X |
| C.OUT | | | X |
| D.OUT | | | X |
| E.OUT | | | X |
| F.OUT | | | X |
| G.OUT | X | | X |
| H.OUT | | | X |
| I.OUT | | | X |
| J.OUT | X | X | |
| K.OUT | | X | |
| K.IN.1 | X | | X |
| K.IN.2 | X | | X |
| K.IN.3 | X | | X |
| L.OUT | | X | |
| M.OUT | | | X |
| N.OUT | | | X |
| O.OUT | | | X |
| P.OUT | | | X |
| Q.OUT | | | |
| ND.OUT | | X | |
| NE.OUT | | X | |
| NF.OUT | | X | |
| NN.OUT | | X | |
| NQ.OUT | | | |

The markings as indicated in Table 1 are provided to 280 of Fig. 5 so the FRONTIER NODES may be determined. Refer now to Fig. 9 for the details of 280. At 281 each FREE node is marked as BLOCKED and otherwise each FORCED ZERO node is marked as FRONTIER. Proceed around the loop headed at 283. Assume that at 285 NN.OUT is the first node processed. All of its sinks are FRONTIER so mark it BLOCKED and NOT FRONTIER. If N.OUT is chosen next, again all of its sinks are BLOCKED so mark it BLOCKED and NOT FRONTIER. Continue in this way until there is no further change in the data structures. Then go to 286 where all nodes are marked NOT FORCED ZERO and NOT FORCED ONE. Tables of the FREE, FRONTIER and BLOCKED values after the completion of 286, that is 280 of Fig. 5 are given in TABLE 2 below.

TABLE 2

NODE MARKING AFTER (280)

| | FREE | FRONTIER | BLOCKED |
|---|---|---|---|
| A.OUT | | X | |
| B.OUT | | | X |
| C.OUT | | | X |
| D.OUT | | | X |
| ND.OUT | | | X |
| E.OUT | | | X |
| NE.OUT | | | X |
| F.OUT | | | X |
| NF.OUT | | | X |
| G.OUT | X | | X |
| H.OUT | | X | |
| I.OUT | | X | |
| J.OUT | X | | X |
| K.OUT | | | |
| K.IN.1 | X | | X |
| K.IN.2 | X | | X |
| K.IN.3 | X | | X |
| L.OUT | | | X |
| M.OUT | | X | |
| N.OUT | | | X |
| NN.OUT | | | X |
| O.OUT | | X | |
| P.OUT | | X | |
| Q.OUT | | | X |
| NQ.OUT | | | X |

The program now proceeds to phase 2 where (as shown in block 300 of Fig. 4) the derived graph is constructed as shown in Fig. 2. Refer now to Fig. 10 at 310, the Source and Sink nodes, and nodes corresponding to the six FRONTIER nodes determined in the previous phase are added to the graph. These last six nodes are also connected to the Sink with edges which each have infinite weight. Then proceed to 320, the details of which are shown in Fig. 11, where w.e is set to 1 for each of the six FRONTIER nodes at 321. The nodes are now traversed in reverse topological order in the loop with the test at 322. On the first iteration, say NODE = L.OUT. Then go through 323 to 324 where it is determined that w.e (L) = 0 and w.o (L) = 1. Next, test B and C. For each of them, w.e = .5 and w.o = 0. Next, test NN where w.e (NN) = 0 and w.o (NN) = 2. Next, N yields w.o (N) = 0 and w.e (N) = 2. Continuing in this fashion, the values listed in TABLE 3 below are found.

TABLE 3

W.E & W.O AFTER (322) FIRST PASS

| | W.E | W.O |
|---|---|---|
| A.OUT | 1 | |
| B.OUT | .5 | |
| C.OUT | .5 | |
| D.OUT | 2 | |
| ND.OUT | | 2 |
| E.OUT | 2 | |
| NE.OUT | | 2 |
| F.OUT | 2 | |
| NF.OUT | | 2 |
| G.OUT | | |
| H.OUT | 1 | |
| I.OUT | 1 | |
| J.OUT | | |
| K.OUT | | |
| K.IN.1 | | |
| K.IN.2 | | |
| K.IN.3 | | |
| L.OUT | | 1 |
| M.OUT | 1 | |
| N.OUT | 2 | |
| N.OUT | | 2 |
| O.OUT | 1 | |
| P.OUT | 1 | |
| Q.OUT | 2 | |
| NQ.OUT | | 2 |

It is found at 330 of Fig. 10 that there are nodes with w.e > 0, so proceed to 340. Refer now to Fig. 12 for the details of 340. Choose a node with maximal w.e, say N is chosen. In 341 mark N FORCED ZERO and connect the Source to DG (N) and finally stack N at 342. Now enter the loop at 343. Set NODE = N at 344 and go through 345 to 346. Since all inputs of NN are FORCED ZERO, stack NN and mark NN FORCED ONE. Now return to 343 and then to 344 where NODE = NN.

Next, go to 345 but this time take the other branch to 347. Here the sinks of NN are marked, which are O and P, FORCED ZERO. Nodes for O and P are added to the derived graph (they are already present in this case so nothing is done) and, in the derived graph, connect N, the predecessor of NN, to O and P, the sinks of NN. Then stack O and P and return to 343.

The process continues in this manner, and eventually there is a return to 320 of Fig. 10 and this process is repeated as well.

Proceed now to Fig. 13 which constructs the complete derived graph after the node splitting and edge weighting of 410-470, and as is shown in Fig. 2. (The graph which was actually produced at the end of phase 2 is identical to that shown in Fig. 2, except that the node pairs M′ and M″, and N′ and N″ would each be a single node, and there would be no weights on the edges.)

Possible connection points of S in the optimized circuit are represented in the derived graph. NOR box G does not appear in the derived graph because G was marked as FREE during phase 2. Nodes M and N had multiple in-edges, so they have been split as described in 430 of Fig. 13. M′ and M″ are now associated with logic node M while N′ and N″ are associated with logic node N. Each derived graph edge is labelled with an edge capacity as described in 450-470. Since the Sink node and nodes M′ and N′ do not correspond to actual nodes in the logic graph, they do not represent legal connection points for S and the in-edges to those nodes have been given infinite capacities. All other edges have capacity one.

The max-flow/min-cut procedure is applied to the derived graph and the cut-set is determined to be nodes A, M″, N″ and Q; these nodes are shaded in Fig. 2.

The final piece of processing as shown in Fig. 14 is to adjust the connections of the signal in question to reflect the cut-set. The current signal should be connected only at circuit nodes which correspond to nodes in the derived graph which are part of the cut-set. The result of this is to remove connects of "s" at B,C,D,E,F,G,H and I; and to make new connects of "s" to M, N and Q. The result of doing this is shown as the optimized circuit in Fig. 3 which is the functional equivalent of the provided logic circuit of Fig. 1, but which has fewer connections.

## Industrial Applicability

It is an object of the invention to provide a network configuration having minimal connections.

It is another object of the invention to take a provided circuit configuration and produce therefrom a final circuit configuration which is the functional equivalent of, and contains fewer connections than, the provided circuit configuration.

It is yet another object of the invention to take a provided logic circuitry implementation in a given technology which circuitry includes n signals and m nodes, and produce a final logic circuitry implementation which is the functional equivalent of, and includes fewer connections between the nodes, than does the original logic circuitry implementation.

It is still another object of the invention to take a provided NAND/NOR logic circuitry implementation in a given technology, which circuitry contains n signals and m nodes and produce therefrom a final circuitry implementation which is the functional equivalent of, and contains fewer connections than, the provided NAND/NOR logic circuitry implementation. A chosen one of the n signals is first processed, and global information is computed for this signal. A graphical representation of connections between the m nodes is derived from the computed global information. A list of nodes that form the graphical representation, and an optimized logic circuitry implementation is provided as a function thereof. Each of the remaining ones of the n signals are processed sequentially, as above, to form successive optimized NAND/NOR logic circuitry implementations, with the processing of the nth signal resulting in the final NAND/NOR logic circuitry implementation. This global approach accomplishes best results. The sequence of selecting the signals for subsequent processing is arbitrary, and a single pass through all the n signals suffices to complete the optimization.

It is a further object of the invention to take an original network configuration having an original set of connections, and including at least one signal and m nodes, and produce therefrom a new network configuration which is the functional equivalent of, and contains fewer connections than, the original network configuration. A determination is made as to which of the m nodes comprise FRONTIER nodes for the one signal in the original network configuration. Then, a new set of connections is determined which generate the same set of FRONTIER nodes for the one signal. Then, the original set of connections in the original network configuration are replaced with the new set of connections for producing the new network configuration.

## Claims

1. A method of taking an original circuit configuration of logic devices (Fig. 1) including n signals and m nodes and producing therefrom a new circuit configuration (Fig. 3) which is the functional equivalent of and contains fewer connections than the original circuit configuration (Fig. 1)
   comprising the following steps:
   a first step (100) of selecting one of the n signals to be the current signal (s),
   a second step (200) of analysing the original circuit configuration (Fig. 1) to determine for each signal in the circuit forcing information relating to the current signal (s), whereby said forcing information indicates, for each signal in the circuit, the logic value of said signal that results from a certain logic of the current signal, or otherwise the fact that the logic value of the current signal has no effect on said signal,
   a third step (200) of determining, for each signal in the circuit, a set of key nodes, i.e. those nodes identified as producing said signal and which are influenced by the current signal,
   a fourth step (300) of constructing a derived graph (Fig. 2) from the forcing information and the key nodes to represent the original circuit configuration (Fig. 1), whereby key nodes are successively inserted in the derived graph and edges are inserted in the derived graph to reflect all forcing due to key nodes currently represented in the derived graph,
   a fifth step (400) of applying a known max-flow/min cut algorithm to the derived graph (Fig. 2) to determine a minimum cut set of the derived graph (Fig. 2),
   a sixth step (500) of using said cut set to produce a different circuit configuration, whereby each signal in the original circuit is connected only to those nodes in the original circuit that correspond to nodes in the cut set of the derived graph, and repeating (600) said first to sixth steps using the successively resulting different circuit configuration for each of the n signals, at the completion of which the different circuit configuration is the new circuit configuration (Fig. 3).

2. Method according to claim 1 wherein the second step comprises
investigating input signals and output signals for each node of the circuit configuration and marking (222, 265) the input signals and the output signals with a first forcing value if they are forced to take the value "1" when the current signal (s) has the value "1", or
marking (224, 274) the input signals and the output signals with a second forcing value if they are forced to take the value "0" when the current signal (s) has the value "1".

3. Method according to any of the above claims wherein the third step comprises
selecting those key nodes in the circuit which are forced to zero by the current signal (s) and from which there is a path to another node which is not forced to zero.

4. Method according to any of the above claims wherein the fourth step comprises the following steps:
marking the input signals and the output signals with a first forcing value if they are forced to take the value "1" when the current signal (s) has the value "1"
   a) constructing (310) a derived graph (Fig. 2) with a source node and a sink node,
   b) adding (310) to the derived graph (Fig. 2) the key nodes determined in the third step,
   c) connecting (310) edges between the key nodes and the sink node,
   for each node in the circuit configuration
   d) estimating (320, Fig. 11) the value of the current signal (s) at the node,
   e) choosing (340) the node in the circuit configuration for which the value is the highest,
   f) adding the chosen node to the derived graph (Fig. 2),
   g) connecting edges between the source node and the chosen node,
   h) propagating the effect of adding the chosen node to the derived graph by adding the necessary edges between nodes in the derived graph (Fig. 2), and
   f) repeating steps d) to h) until no new nodes can be added to the derived graph (Fig.2).

5. Method according to any of the above claims wherein the fifth step comprises the following steps:
   (1) selecting (410) a node (N) in the derived graph (Fig. 2):
   (2) determining (420) if the selected node (N) has more than one input edge, and if not then go to step (4),
   (3) splitting (430) the selected node (N) into two new nodes (N', N''), and copying the input edges from the selected node (N) to the first new node (N'), and building an edge between the first new node (N') and the second new node (N''), and copying the output edges of the selected node (N) to the second new node (N''), and associate the selected node (N) with the two new nodes (N',N''),
   (4) determining (440) if there are more nodes in the derived graph, and if so then go to step (1),
   (5) selecting (450) an edge from the derived graph,
   (6) determining (460) if the to-node of the edge is a legal connection point, and if so then assign a capacity to the edge which describes the desirability of having a connection of the given signal at this point, if not then assigning an infinite capacity to the edge,
   (7) determining (470) if there are more edges in the derived graph (Fig. 2), and if so then return to step (5),
   (8) applying (480) the known max-flow/min-cut analysis to the derived graph (Fig. 2) and deriving therefrom the list of nodes that form a cut-set.

6. Method according to any of the above claims wherein the sixth step comprises the following steps:
   (1) getting (510) a node from the cut-set of said derived graph (Fig. 2) and getting the corresponding node in the circuit configuration (Fig. 1),
   (2) determining (520) if the current signal (s) is connected to the logic node, and if not then connect it,
   (3) determining (530) if there are more nodes in the cut-set, and if so repeat steps (1), (2) and (3),
   (4) getting (540) a sink node of the current signal (s) in the circuit configuration (Fig. 1) and getting the corresponding node in said derived graph (Fig. 2),
   (5) determining (550) if said sink node is in said cut-set, and if not then disconnect it (560);
   (6) determining (570) if there are more sink nodes in the circuit configuration (Fig. 1), if so then repeat steps (4), (5) and (6), if not then the new circuit configuration (Fig. 3) is complete.

## Patentansprüche

1. Verfahren, bei dem eine ursprüngliche Schaltungskonfiguration logischer Bauelemente (Fig. 1) mit n Signalen und m Knoten genommen wird und daraus eine neue Schaltungskonfiguration (Fig. 3) erzeugt wird, die der ursprünglichen Schaltungskonfiguration (Fig. 1) funktionell gleichwertig ist und weniger Verbindungen als diese enthält,

   das die folgenden Schritte umfaßt:

   einen ersten Schritt (100) des Auswählens eines der n Signale als aktuelles Signal (s),

   einen zweiten Schritt (200) des Analysierens der ursprünglichen Schaltungskonfiguration (Fig. 1), um für jedes Signal in der Schaltung Zwangssetzungsinformation betreffs des aktuellen Signals (s) zu bestimmen, wodurch die Zwangssetzungsinformation für jedes Signal in der Schaltung den logischen Wert des Signals anzeigt, der aus einen definierten logischen Wert des aktuellen Signals resultiert, oder andernfalls die Tatsache anzeigt, daß der logische Wert des aktuellen Signals keine Wirkung auf das Signal hat,

   einen dritten Schritt (200) des Bestimmens einer Gruppe von Schlüsselknoten für jedes Signal in der Schaltung, d.h. derjenigen Knoten, die als Urheber des Signals identifiziert wurden und die vom aktuellen Signal beeinflußt werden,

   einen vierten Schritt (300) des Erzeugens einer abgeleiteten graphischen Darstellung (Fig. 2) aus der Zwangssetzungsinformation und den Schlüsselknoten, welche die ursprüngliche Schaltungskonfiguration darstellen sollen (Fig. 1), wodurch die Schlüsselknoten schrittweise in die abgeleitete graphische Darstellung eingesetzt werden und Flanken in die abgeleitete graphische Darstellung eingefügt werden, die alle Zwangssetzungen aufgrund der aktuell in der abgeleiteten graphischen Darstellung vertretenen Schlüsselknoten widerspiegeln,

   einen fünften Schritt (400) des Anwendens eines bekannten Algorithmus maximalen Durchsatzes/minimalen Schaltungsweges auf die abgeleitete graphische Darstellung (Fig. 2), um einen minimalen kompletten Schaltungsweg der abgeleiteten graphischen Darstellung (Fig. 2) zu bestimmen,

   einen sechsten Schritt (500) des Verwendens des kompletten Schaltungsweges zum Erzeugen einer unterschiedlichen Schaltungskonfiguration, wodurch jedes Signal in der ursprünglichen Schaltung nur mit den Knoten in der ursprünglichen Schaltung verbunden wird, die Knoten im kompletten Schaltungsweg der abgeleiteten graphischen Darstellung entsprechen, und

   Wiederholen (600) der ersten bis sechsten Schritte unter Benutzung der schrittweise für jedes der n Signale resultierenden unterschiedlichen Schaltungskonfiguration, so daß bei deren Abschluß die unterschiedliche Schaltungskonfiguration die neue Schaltungskonfiguration ist (Fig. 3).

2. Verfahren gemäß Anspruch 1, wobei der zweite Schritt umfaßt

   Untersuchen der Eingangssignale und der Ausgangssignale an jedem Knoten der Schaltungskonfiguration und Markieren (222, 265) der Eingangssignale und der Ausgangssignale mit einem ersten Zwangssetzungswert, falls sie zwangsgesetzt auf den Wert "1" sind, wenn das aktuelle Signal (s) den Wert "1" hat, oder

   Markieren (224, 274) der Eingangssignale und der Ausgangssignale mit einem zweiten Zwangssetzungswert, falls sie zwangsgesetzt auf den Wert "0" sind, wenn das aktuelle Signal (s) den Wert "1" hat.

3. Verfahren gemäß eines beliebigen der obigen Ansprüche, wobei der dritte Schritt umfaßt

   Auswählen derjenigen Schlüsselknoten in der Schaltung, die durch das aktuelle Signal (s) zwangsweise auf Null gesetzt werden und von denen es einen Weg zu einem anderen Knoten gibt, der nicht zwangsweise auf Null gesetzt ist.

4. Verfahren gemäß eines beliebigen der obigen Ansprüche, wobei der vierte Schritt die folgenden Schritte umfaßt:

   Markieren der Eingangssignale und der Ausgangssignale mit einem ersten Zwangssetzungswert, falls sie zwangsweise auf den Wert "1" gesetzt werden, wenn das aktuelle Signal (s) den Wert "1" hat,

   a) Erzeugen (310) einer abgeleiteten graphischen Darstellung (Fig. 2) mit einem Quellenknoten und einem Senkenknoten,

   b) Hinzufügen (310) der im dritten Schritt bestimmten Schlüsselknoten zur abgeleiteten graphischen Darstellung (Fig. 2),

   c) Verbinden (310) von Flanken zwischen den Schlüsselknoten und dem Senkenknoten,

   für jeden Knoten in der Schaltungskonfiguration

   d) Abschätzen (320, Fig. 11) des Wertes des aktuellen Signals (s) am Knoten,

   e) Auswählen (340) des Knotens in der Schaltungskonfiguration, für den der Wert am höchsten ist,

f) Hinzufügen des ausgewählten Knotens zur abgeleiteten graphischen Darstellung (Fig. 2),

g) Verbinden der Flanken zwischen dem Quellenknoten und dem ausgewählten Knoten,

h) Fortpflanzen der Wirkung des Hinzufügens des gewählten Knotens zur abgeleiteten graphischen Darstellung, indem die notwendigen Flanken zwischen Knoten in der abgeleiteten graphischen Darstellung (Fig. 2) hinzugefügt werden,

i) Wiederholen der Schritte d) bis h), bis der abgeleiteten graphischen Darstellung (Fig. 2) keine neuen Knoten hinzugefügt werden können.

5. Verfahren gemäß eines beliebigen der obigen Ansprüche, wobei der fünfte Schritt die folgenden Schritte umfaßt:

(1) Auswählen (410) eines Knotens (N) in der abgeleiteten graphischen Darstellung (Fig. 2):

(2) Bestimmen (420), ob der ausgewählte Knoten (N) mehr als eine Eingangsflanke hat, und wenn nicht, dann weiter zu Schritt (4),

(3) Aufteilen (430) des ausgewählten Knotens (N) in zwei neue Knoten (N', N'') und Kopieren der Eingangsflanken vom ausgewählten Knoten (N) zum ersten neuen Knoten (N') und Aufbauen einer Flanke zwischen dem ersten neuen Knoten (N') und dem zweiten neuen Knoten (N'') und Kopieren der Ausgangsflanken des ausgewählten Knotens (N) auf den zweiten neuen Knoten (N'') und Verbinden des ausgewählten Knotens (N) mit den beiden neuen Knoten (N', N''),

(4) Bestimmen (440), ob es noch mehr Knoten in der abgeleiteten graphischen Darstellung gibt, und wenn dies der Fall ist, dann weiter zu Schritt (1),

(5) Auswählen (450) einer Flanke aus der abgeleiteten graphischen Darstellung,

(6) Bestimmen (460), ob der an der Flanke gelegene Knoten ein gesetzmäßiger Verbindungspunkt ist, und wenn dies der Fall ist, dann Zuordnen einer Kapazität zur Flanke, mit welcher der Wunsch nach einer Verbindung des gegebenen Signals an diesem Punkt beschrieben wird, wenn dies nicht der Fall ist, dann Zuordnen einer unendlichen Kapazität zur Flanke,

(7) Bestimmen (470), ob es in der abgeleiteten graphischen Darstellung (Fig. 2) weitere Flanken gibt, und wenn dies der Fall ist, dann Zurückkehren zu Schritt (5),

(8) Anwenden (480) der bekannten Analyse maximalen Durchsatzes/minimalen Schaltungsweges auf die abgeleitete graphische Darstellung (Fig. 2) und Ableiten der Liste der Knoten daraus, die den kompletten Schaltungsweg bilden.

6. Verfahren gemäß eines beliebigen der obigen Ansprüche, wobei der sechste Schritt die folgenden Schritte umfaßt:

(1) Erhalt (510) eines Knotens aus dem kompletten Schaltungsweg der abgeleiteten graphischen Darstellung (Fig. 2) und Erhalt des entsprechenden Knotens in der Schaltungskonfiguration (Fig. 1),

(2) Bestimmen (520), ob das aktuelle Signal (s) mit dem Logikknoten verbunden ist, und wenn nicht, dann Verbinden,

(3) Bestimmen (530), ob es weitere Knoten im kompletten Schaltungsweg gibt, und wenn dies der Fall ist, Wiederholen der Schritte (1), (2) und (3),

(4) Erhalt (540) eines Senkenknotens des aktuellen Signals (s) in der Schaltungskonfiguration (Fig. 1) und Erhalt des entsprechenden Knotens in der abgeleiteten graphischen Darstellung (Fig. 2),

(5) Bestimmen (550), ob der Senkenknoten sich innerhalb des kompletten Schaltungsweges befindet, und wenn nicht, dann sein Abkoppeln (560);

(6) Bestimmen (570), ob es weitere Senkenknoten in der Schaltungskonfiguration (Fig. 1) gibt, und wenn dies der Fall ist, Wiederholen der Schritte (4), (5) und (6), wenn nicht, dann ist die neue Schaltungskonfiguration (Fig. 3) vollständig.


**Revendications**

1. Procédé pour prendre une configuration de circuit originale de dispositifs logiques (Figure 1) comprenant n signaux et m noeuds et pour en déduire une nouvelle configuration de circuit (Figure 3) qui en est l'équivalent fonctionnel et qui comporte moins de connexions que la configuration de circuit originale (Figure 1)

comprenant les étapes suivantes :

une première étape (100) de sélection d'un signal parmi les n signaux, destiné à être le signal courant (s),

une seconde étape (200) d'analyse de la configuration de circuit originale (Figure 1) pour déterminer pour chaque signal du circuit une information de forçage se rapportant au signal courant (s), ladite information de forçage indiquant, pour chaque signal dans le circuit, la valeur logique dudit signal qui résulte d'une certaine valeur logique du signal courant, ou alors le fait que la valeur logique du signal courant n'a pas d'effet sur ledit signal,

une troisième étape (200) pour déterminer, pour chaque signal dans le circuit, un ensemble de noeuds clés, c'est-à-dire ceux des noeuds identifiés comme produisant ledit signal et qui sont influencés par le signal courant,

une quatrième étape (300) de construction d'un graphe dérivé (Figure 2) de l'information de forçage et des noeuds clés pour représenter la configuration de circuit originale (Figure 1), de sorte que les noeuds clés sont successivement insérés dans le graphe dérivé et que les bords sont insérés dans le graphe dérivé pour rendre compte de tout le forçage dû aux noeuds clés couramment représentés dans le graphe dérivé,

une cinquième étape (400) d'application d'un algorithme connu de flux-maximal/coupure minimale au graphe dérivé (Figure 2) pour déterminer un ensemble réduit minimal du graphe dérivé (Figure 2),

une sixième étape (500) d'utilisation dudit ensemble réduit pour produire une configuration de circuit différente, de sorte que chaque signal dans le circuit original est connecté uniquement à ceux des noeuds du circuit original qui correspondent à des noeuds de l'ensemble réduit du graphe dérivé, et

répéter (600) lesdites première à sixième étapes en utilisant la configuration de circuit différente résultante pour chacun des n signaux, à la suite de quoi la configuration de circuit différente représente la nouvelle configuration de circuit (Figure 3).

2. Procédé selon la revendication 1, dans lequel la deuxième étape comporte
l'examen de signaux d'entrée et de signaux de sortie pour chaque noeud de la configuration de circuit et le marquage (222, 265) des signaux d'entrée et des signaux de sortie avec une première valeur de forçage s'ils sont forcés de prendre la valeur "1" lorsque le signal courant (s) présente la valeur "1", ou
marquer les signaux d'entrée (224, 274) et les signaux de sortie avec une seconde valeur de forçage s'ils sont forcés de prendre la valeur "0" lorsque le signal courant (s) présente la valeur "1".

3. Procédé selon l'une quelconque des revendications précédentes, dans lequel la troisième étape comporte la sélection de ceux des noeuds clés dans le circuit qui sont forcés à zéro par le signal courant (s) et à partir desquels il existe un chemin vers un autre noeud qui n'est pas forcé à zéro.

4. Procédé selon l'une quelconque des revendications précédentes, dans lequel la quatrième étape comporte les étapes suivantes :
marquer les signaux d'entrée et les signaux de sortie avec une première valeur de forçage s'ils sont forcés de prendre la valeur "1" lorsque le signal courant (s) présente la valeur "1".
   a) construire (310) un graphe dérivé (Figure 2) avec un noeud source et un noeud puits,
   b) ajouter (310) au graphe dérivé (Figure 2) les noeuds clés déterminés dans la troisième étape,
   c) connecter (310) les bords entre les noeuds clés et le noeud puits,
   pour chaque noeud dans la configuration de circuit
   d) estimer (320, Figure 11) la valeur du signal courant (s) au noeud,
   e) choisir (340) le noeud dans la configuration de circuit pour lequel la valeur est la plus élevée,
   f) ajouter le noeud choisi au graphe dérivé (Figure 2),
   g) connecter les bords entre le noeud source et le noeud choisi,
   h) propager l'effet de l'addition du noeud choisi au graphe dérivé en ajoutant les bords nécessaires entre les noeuds dans le graphe dérivé (Figure 2), et
   f) répéter les étapes d) à h) jusqu'à ce qu'il ne puisse plus être ajouté de nouveaux noeuds au graphe dérivé (Figure 2).

5. Procédé selon l'une quelconque des revendications précédentes, dans lequel la cinquième étape comporte les étapes suivantes :
   (1) sélectionner (410) un noeud (N) dans le graphe dérivé (Figure 2) :
   (2) déterminer (420) si le noeud sélectionné (N) présente plus d'un bord d'entrée, et sinon aller à l'étape (4),
   (3) diviser (430) le noeud choisi (N) en deux nouveaux noeuds (N', N''), et copier les bords d'entrée du noeud choisi (N) vers le premier nouveau noeud (N'), et construire un bord entre le premier noeud nouveau (N') et le second noeud nouveau (N''), et copier les bords de sortie du noeud choisi (N) vers le second noeud nouveau (N''), et associer le noeud sélectionné (N) aux deux nouveaux noeuds (N', N''),

(4) déterminer (440) s'il y a plus de noeuds dans le graphe dérivé, et si oui aller à l'étape (1),

(5) choisir (450) un bord du graphe dérivé,

(6) déterminer (460) si le noeud du bord est un point de connexion autorisé, et si oui affecter une capacité au bord décrivant l'intérêt d'avoir une connexion du signal donné à ce point, sinon affecter une capacité infinie au bord,

(7) déterminer (470) s'il y a plus de bords dans le graphe dérivé (Figure 2), et si oui retourner à l'étape (5),

(8) appliquer (480) l'analyse connue de flux maximal/-réduction minimale au graphe dérivé (Figure 2) et en déduire la liste des noeuds qui forment un ensemble réduit.

6. Procédé selon l'une quelconque des revendications précédentes, dans lequel la sixième étape comporte les étapes suivantes :

(1) obtenir (510) un noeud à partir de l'ensemble réduit dudit graphe dérivé (Figure 2) et obtenir le noeud correspondant dans la configuration de circuit (Figure 1),

(2) déterminer (520) si le signal courant (s) est connecté au noeud logique, et sinon le connecter,

(3) déterminer (530) s'il y a plus de noeuds dans l'ensemble réduit et si oui répéter les étapes (1), (2) et (3),

(4) obtenir (540) un noeud puits du signal courant (s) dans la configuration de circuit (Figure 1) et obtenir le noeud correspondant dans ledit graphe dérivé (Figure 2),

(5) déterminer (550) si ledit noeud puits est dans ledit ensemble réduit, et sinon le déconnecter (560),

(6) déterminer (570) s'il y a plus de noeuds puits dans le circuit de configuration (Figure 1), et si oui répéter les étapes (4), (5) et (6), sinon la nouvelle configuration de circuit (Figure 3) est terminée.

# FIG. 1

FIG. 2

# FIG. 3

# F I G. 4

START

CHOOSE A SIGNAL FROM
THE LOGIC CIRCUIT — 100

COMPUTE GLOBAL INFORMATION
ABOUT THE SIGNAL FROM THE LOGIC CIRCUIT — 200

FORM A DERIVED GRAPH
OF CONNECTION POINTS — 300

APPLY A MAX-FLOW/MIN-CUT
ALGORITHM TO THE DERIVED GRAPH — 400

ADJUST THE LOGIC CIRCUIT USING
THE CUT-SET INFORMATION FIG.14 — 500

YES ◇ ARE THERE
MORE SIGNALS ? 600

NO

EXIT

# FIG.5

INITIALIZE

PUT SIG ON STACK MARK SIG "FORCED ONE" —210

200

PUT "FREE" SIGNALS ON STACK (FIG.6) —220

STACK ≠ ∅ —230

NO (SEE TABLE 1)

YES

NODE=TOP —240

DETERMINE FRONTIER NODES (FIG.9) —280

(SEE TABLE 2)
TO PHASE 2

IS NODE "FORCED ZERO" —250

YES

NO

NODE IS "FORCED ZERO" (FIG.7) —260

NODE IS "FORCED ONE" (FIG.8) —270

EP 0 283 724 B1

# FIG.6

220

221 — CHOOSE NEW GATE WITH
ALL BUT ONE SIGNAL
"FREE"&"FORCED ZERO"

NO SUCH GATE

GATE EXITS

223 — CHOOSE NEW GATE WITH
OUTPUT "FORCED ONE"

222
MARK UNMARKED SIGNAL
"FREE"&"FORCED ONE"

NO SUCH GATE

GATE EXITS

225
PUT EACH SIGNAL, MARKED
"FORCED ZERO" WHICH IS (INPUT OR REG)
OR WHICH HAS ≥1 UNMARKED
INPUT, ON STACK

224
MARK ALL INPUTS
"FREE" & "FORCED ZERO"

TO 230 (FIG.5)

EP 0 283 724 B1

# FIG. 7

FIG.8

```
                          271
              ┌─────────────────┐
              │  CHOOSE NEW SINK │ ──── ALL SINKS ────→ TO 230
              │     OF NODE      │      PROCESSED         (FIG.5)
              │        ?         │
              └─────────────────┘
                       │
                       ▼
              ┌─────────────────┐
              │   T = OUTPUT     │── 272
              │  CURRENT SINK    │
              └─────────────────┘
                       │
                       ▼         273
              ┌─────────────────┐
   YES ←──────│    T MARKED     │
              │ "FORCED ZERO"   │
              │        ?        │
              └─────────────────┘
                       │ NO              ── 270
                       ▼
              ┌─────────────────┐
              │     MARK T      │── 274
              │ "FORCED ZERO"   │
              └─────────────────┘
                       │
                       ▼          275           NO
              ┌─────────────────┐
              │ NODE MARKED"FREE"? │ ────────────┐
              └─────────────────┘                │
                       │ YES                     │
                       ▼                          │
              ┌─────────────────┐                │
              │  MARK T "FREE"  │── 276           │
              └─────────────────┘                │
                       │ ←──────────────────────┘
                       ▼
              ┌─────────────────┐
              │  PUT T ON STACK │── 277
              └─────────────────┘
```

EP 0 283 724 B1

# FIG.9

```
           FOR EVERY NODE
       IF "FREE" MARK "BLOCKED"        281
      ELSE IF "FORCED ZERO"
          MARK "FRONTIER"
```

```
          CHANGE = 1        282
```
                                                    280

```
283      DO WHILE CHANGE ?
```
                                                                    286

```
          CHANGE = '0'        284
```

```
           MARK ALL NODES
          NOT "FORCED ZERO"
           NOT "FORCED ONE"
```

```
        FOR ANY NODE ( ≠ CURRENT SIG )
    IF EVERY SINK MARKED "BLOCKED" | "FRONTIER"
         THEN DO: MARK "BLOCKED"            285
           MARK NOT "FRONTIER"
             CHANGE = '1'
              END;
```

```
         TO PHASE 2
       (SEE TABLE 2)
```

FIG.10

ADD NODE TO DG FOR
EACH "FRONTIER" NODE

CONNECT THESE NODES
TO SINK

— 310

300

ESTIMATE VALUE OF
CONNECTION OF "SIG"
AT EACH LEGAL NODE

(FIG.11)

— 320

(SEE TABLE 3)

330

"BLOCKED" OR
"FRONTIER" NODE HAS
W-E (NODE) > 0

NO

CONSTRUCTION OF
DERIVED GRAPH COMPLETE

YES

MARK NODE WITH HIGHEST
W-E "CHOSEN"

— 340

ADD DG (NODE) TO DG

CONNECT SOURCE TO
DG (NODE)

(FIG.12)

PROPAGATE EFFECT OF
NEW "CHOSEN NODE"

## FIG.11

320

FOR EACH NODE IN CIRCUIT IF DG(NODE)
EXISTS & HAS NO PREDECESSOR
THEN W.E (NODE) = 1
ELSE W.E (NODE) = 0
W.O (NODE) = 0

321

322

NODE = NEXT?

ALL NODES
PROCESSED

END
(SEE TABLE 3)

323

YES

DG(NODE) EXISTS &
HAS PREDECESSOR ?

NO

FOR EACH SINK OF NODE:

$$W.E \; (NODE) = W.E \; (NODE) + \frac{W.O \; (SINK(NODE))}{FANIN \; (SINK(NODE))}$$

$$W.O \; (NODE) = W.E \; (SINK(NODE)) + W.O \; (NODE)$$

324

325

NO

NODE "FREE" ?

YES

W.E (NODE) = 0
W.O (NODE) = 0

326

FIG.12

```
                    ┌─────────────────────────────────────────┐
                    │ MARK NODE WITH HIGHEST W.E"FORCED ZERO"  │
                    │        ADD DG(NODE) TO DG                │──341
                    │     CONNECT SOURCE TO DG(NODE)           │
                    └─────────────────────────────────────────┘
                                     │
                            ┌─────────────────┐
                            │   STACK NODE    │──342
                            └─────────────────┘
                                     │
                                     ▼                        340
                            ◇ WHILE STACK ≠ Ø ? ◇───343  Ø ───────
                                     │
                            ┌─────────────────┐
                            │   NODE = POP    │──344
                            └─────────────────┘
                                     │
                   YES       ◇ NODE IS ◇──345  NO           347
                    ┌────────◇ FORCED ZERO ? ◇──────────┐
          346       │                                   ▼
┌──────────────────────────────┐      ┌─────────────────────────────────────┐
│     FOR EACH SINK OF NODE:    │      │      FOR EACH SINK OF NODE:         │
│ IF ALL INPUTS OF SINK ARE"FORCED ZERO"│   │ 1) MARK SINK "FORCED ZERO"        │
│         1) STACK SINK         │      │ 2) ADD DG(SINK) TO DG               │
│         2) MARK SINK          │      │ 3) FOR EACH PREDECESSOR OF          │
│          "FORCED ONE"         │      │    NODE IN CIRCUIT:                 │
│                               │      │    CONNECT DG(PREDECESSOR) TO DG(SINK)│
│                               │      │ 4) STACK SINK                       │
└──────────────────────────────┘      └─────────────────────────────────────┘
```

FIG.13

START

410 — SELECT A NODE IN THE DERIVED GRAPH

420 — DOES THE NODE HAVE MORE THAN ONE INPUT EDGE? — NO

400

YES

430 — SPLIT THE NODE INTO TWO NODES. COPY THE INPUT EDGES FROM THE ORIGINAL NODE TO THE FIRST NEW NODE. BUILD AN EDGE BETWEEN THE FIRST NEW NODE AND THE SECOND NEW NODE. COPY THE OUT-EDGE OF THE ORIGINAL NODE TO THE SECOND NEW NODE. ASSOCIATE THE LOGIC NODE WITH THE SECOND NEW NODE.

440 — ARE THERE MORE NODES IN THE DERIVED GRAPH? — YES

NO

450 — SELECT AN EDGE FROM THE DERIVED GRAPH?

460 — IS THE TO-NODE OF THE EDGE A LEGAL CONNECTION POINT?

YES — ASSIGN CAPACITY 1

NO — ASSIGN INFINITE CAPACITY

470 — ARE THERE MORE EDGES IN THE DERIVED GRAPH? — YES

NO

480 — APPLY A STANDARD MAX-FLOW/MIN-CUT ALGORITHM TO THE DERIVED GRAPH. THIS RESULTS IN A LIST OF NODES IN THE DERIVED GRAPH THAT FORM A CUT-SET.

EXIT

# FIG. 14

500

510

START

GET A NODE FROM THE CUT-SET OF THE DERIVED GRAPH
GET THE CORRESPONDING NODE IN THE LOGIC GRAPH

520

IS THE SIGNAL CONNECTED
TO THE LOGIC NODE?

YES

NO

CONNECT IT

530

ARE THERE MORE
NODES IN THE CUT-SET?

YES

NO

540

GET A SINK NODE OF THE SIGNAL IN THE LOGIC GRAPH
GET A CORRESPONDING DERIVED GRAPH NODE

550

IS THE LOGIC NODE
IN THE CUT-SET?

YES

NO

560

DISCONNECT IT

570

ARE THERE MORE SINKS
IN THE LOGIC GRAPH?

YES

NO

EXIT